# EUROPEAN PATENT APPLICATION

(11) **EP 2 131 641 A1**
(43) Date of publication of application: **09.12.2009**
(21) Application number: 08157529.2
(22) Date of filing: 04.06.2008
(51) Int. Cl.: H05K 7/20, F28F 3/12

(54) **Cooling element for an electrical circuit**

(71) Applicant: ABB Oy, 00380 Helsinki (FI)
(72) Inventor: Koivuluoma, Timo, 01710 Vantaa (FI); Sikanen, Jukka, 02650 Espoo (FI); Elomaa, Heikki, 00200 Helsinki (FI)
(74) Representative: Holmström, Stefan Mikael

(57) **Abstract**

The invention relates to a cooling element (1) for an electrical circuit (12), comprising: a base plate (3), a cover plate (2) with a first surface (7) for receiving said electrical circuit (12), walls (4) extending between said base plate (3) and a second surface (9) of said cover plate (2), said walls limiting a flow channel extending back and forth between the base plate (3) and the cover plate (2), an inlet for introducing a cooling fluid into said flow channel, and an outlet for removing said cooling fluid from said flow channel. In order to provide a novel and efficient cooling element at least one leak point (21) is arranged at said walls (4) to allow a part of said cooling fluid (11) to leak past at least one of said walls between parts of the flow channel which are located on opposite sides of said at least one wall (4).

## Description

### BACKGROUND OF THE INVENTION

### 1. Field of the Invention

This invention relates to a cooling element for an electrical circuit, which cooling element comprises a flow channel for feeding a cooling fluid through the cooling element.

### 2. Description of Prior Art

Previously there is known a cooling element comprising a base plate and a cover plate limiting between them a flow channel extending back and forth. The flow channel consists of grooves which have been machined into one of the plates in a desired labyrinth pattern. The other one of the two plates is arranged on top of the one with the grooves, after which the two metal plates have been attached to each other by brazing or soldering at the areas located between the grooves. The cooling fluid entering the flow channel through an inlet has to proceed through the entire flow channel before reaching an outlet, as the brazing or soldering prevents any internal leakage past the walls of the flow channel, which consists of the areas located between the grooves. Brazing or soldering also stiffens the structure. Also structures with gluing or mechanical attachment sealed with gaskets are used especially when other plate is made of plastics etc.

A drawback with the above described prior art cooling element is the pressure difference between the inlet and the outlet. More precisely, a significant pressure is needed to force the cooling fluid to flow through the entire flow channel of the cooling element. Consequently, a lot of energy is needed to achieve an efficient cooling with this prior art cooling element.

### SUMMARY OF THE INVENTION

An object of the present invention is to solve the above mentioned drawback and to provide a novel and efficient cooling element. This is achieved with the cooling element of independent claim 1.

In the present invention an efficient cooling of the entire cover plate, to which the electrical circuit is attached, is ensured by utilizing a cooling channel extending back and forth between the base plate and the cover plate. However, in order to reduce the pressure loss between the inlet and the outlet of the flow channel due to the shape of the flow channel, at least one leak point is arranged to at least one of the walls delimiting the flow channel. In this leak point a cooling fluid is allowed to leak past the wall between parts of the flow channel which are located on opposite sides of this wall.

An advantage obtained with the above mentioned solution is that it is not necessary that the entire cooling fluid passes through the entire flow channel, but instead a part of the cooling fluid is allowed to take a shorter route via a leak point. In this way the pressure loss between the inlet and the outlet is reduced and less energy is needed to transport the cooling fluid through the cooling element.

Preferred embodiments of the invention are disclosed in the dependent claims.

### BRIEF DESCRIPTION OF DRAWINGS

In the following the present invention will be described in closer detail by way of example and with reference to the attached drawings, in which
Figures 1 and 2 illustrate a first preferred embodiment of a cooling element,
Figure 3 illustrates a flow of a cooling fluid through a cooling element without leak points,
Figure 4 illustrates a flow of a cooling fluid through a cooling element with leak points,
Figures 5 and 6 show side views of alternative walls for the cooling element of Figures 1 and 2, and
Figures 7 to 13 show cross sections of alternative walls for the cooling element of Figures 1 and 2.

### DESCRIPTION OF AT LEAST ONE EMBODIMENT

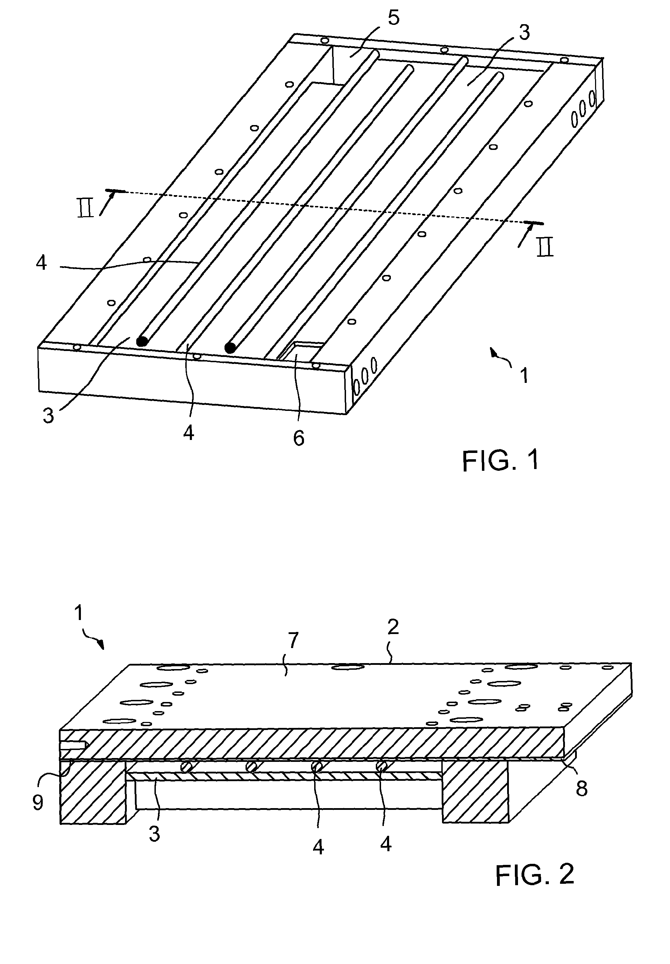

Figures 1 and 2 illustrate a first preferred embodiment of a cooling element 1. In Figure 1 the cooling element 1 is shown with a cover plate 2 removed, and Figure 2 is a cross section of the cooling element 1 (with the cover plate) along line II - II of Figure 1.

The cooling element of Figures 1 and 2 comprises a base plate 3 on which walls 4 are arranged. These 4 walls extend between the base plate 3 and the cover plate 2. The walls 4 have been arranged in a pattern which results in a flow channel that extends back and forth in the space between the base plate 3 and the cover plate 2. Such a labyrinth pattern ensures that substantially the entire area of the cover plate 2 is efficiently cooled by the cooling fluid which enters the cooling element through the inlet 5, flows through the flow channel delimited by the walls 4, and exits from the cooling element 1 through the outlet 6. Due to efficient cooling of the entire area of the cover plate 2, the entire upper first surface 7 of the cover plate can be used for attaching an electrical circuit or electrical circuits.

An alternative way of accomplishing the labyrinth pattern for the cooling element is to machine groves into the base plate, in which case these grooves function as the flow channel and the areas between the grooves in the base plate function as the walls.

The cover plate 2 is preferably manufactured from a stiff material with excellent heat conducting properties. In this way, the electrical circuit attached to the cover plate can be protected against bending and the heat generated by the electrical circuit can be conducted through the cover plate to the cooling fluid. Suitable materials include copper, aluminum and stainless steel, for instance. Copper and aluminum have much better heat conducting properties, but the drawback that they are not suitable for use with all cooling fluids due to risk of corrosion.

In order to avoid the risk of corrosion, a corrosion protection layer 8 is in Figure 2 arranged to cover the entire lower second surface 9 of the cover plate 2. This corrosion protection layer 8 prevents the cooling fluid and the walls 4 from coming into contact with the cover plate, thereby allowing a greater freedom of choice regarding the material of the cover plate 2. The corrosion protection layer 8 may consist of a separate plate of a suitable material, such as plastic, stainless steel, titanium and ceramics like alumina, which is arranged under the cover plate. In case the cooling element 1 is designed for use with a low pressure drop (suction of the cooling fluid through the outlet 6), but with high pressure levels such a separate plate is preferably stiff. Alternatively the corrosion protection layer 8 may consist of a coating of a suitable material arranged to cover the second surface 9 of the cover plate 2.

In the embodiment of Figures 1 and 2 it is assumed that the walls 4 consist of elongated bars with a circular cross section. These bars are arranged on top of the base plate 3 without attaching or sealing them to the bottom plate. Similarly, the cover plate 2 (with or without a corrosion protection layer 8) can be placed on top of the walls 4 to apply a force pressing the walls towards the base plate 3. The elongated bars are therefore unattached in the cooling element, and they are kept in place simply by friction and the pressing forces applied by the base plate 3 and the cover plate 2 or the corrosion protection layer 8, respectively.

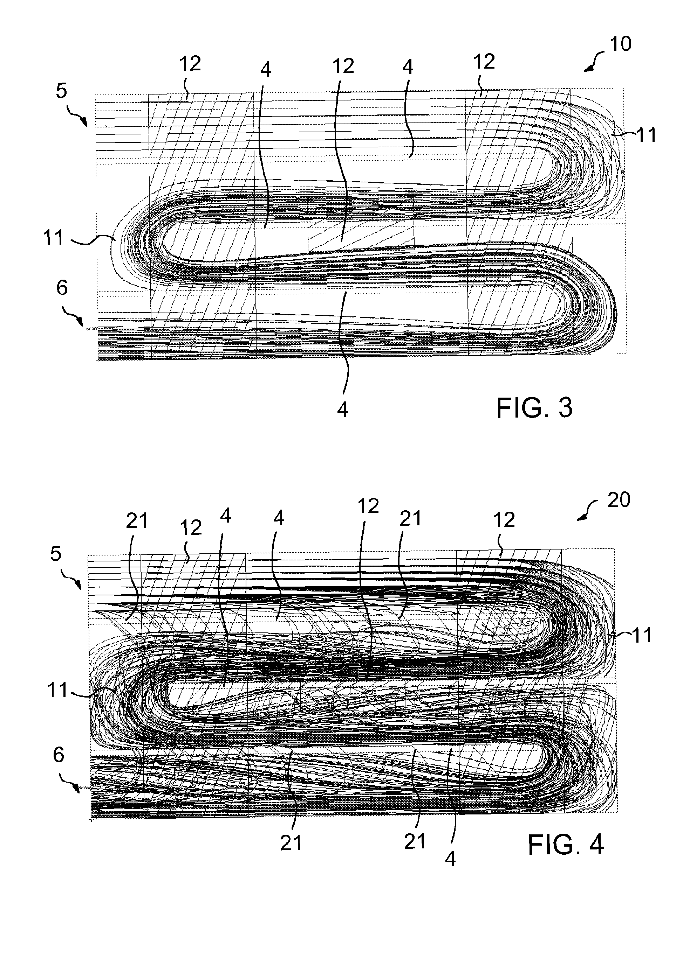

Figure 3 illustrates a flow of a cooling fluid 11 through a cooling element without leak points. The construction of the cooling element 10 is similar to the one illustrated in Figures 1 and 2, except for the number of walls 4. In Figure 3, only three walls 4 are in use, for simplicity. Electrical circuits 12 to be attached to the cover plate are also illustrated in Figure 3.

In can be seen from Figure 3 that due to the non-leaking construction the entire cooling fluid 11 has to travel through the entire flow channel of the cooling element. Consequently, a significant loss of pressure will occur between the inlet 5 and the outlet 6 of the cooling element.

Figure 4 illustrates a flow of a cooling fluid 11 through a cooling element 20 with leak points 21. The construction of the cooling element 20 is similar to the one illustrated in Figure 3, except for the leak points 21 arranged along each one of the three walls 4.

As can be seen from Figure 4, a part of the cooling fluid 11 is allowed to leak past the walls 4 without having to travel back and forth through the entire flow channel. Due to this controlled leakage, the loss of pressure between the inlet 5 and the outlet 6 is smaller that in the case of Figure 3. In addition the cooled surface area increases as cooling occurs also at the leak points, and the cooling becomes more efficient, because the leakages at the leak points generates turbulence in the flow channel which enhances heat transfer between the cover plate and the cooling fluid. Simulations carried out indicate that the leakage can be used for reducing pressure lost without significant reduction in the efficiency of the heat transfer, as compared to prior art solutions. In addition, it seems even possible to use the leakage to reduce pressure lost and to increase the heat transfer simultaneously, as compared to prior art solutions.

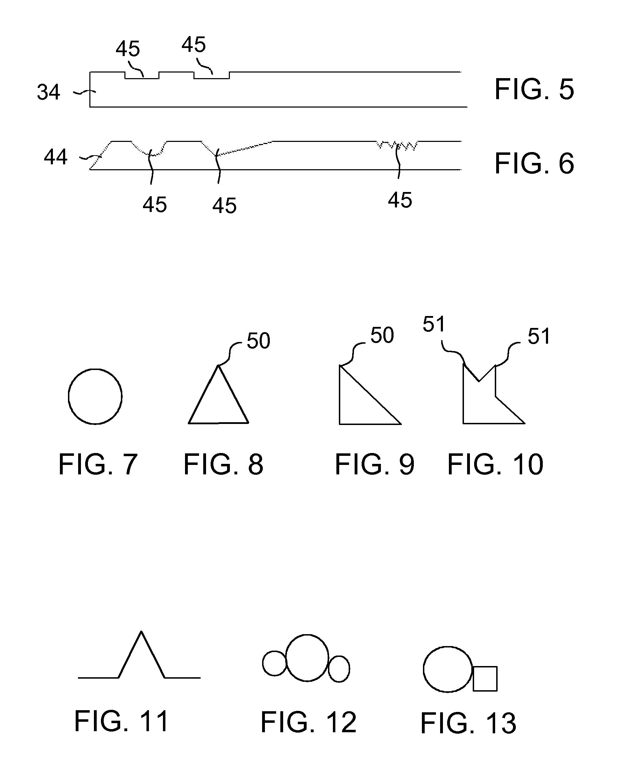

There exists several alternatives how to accomplish the leak points 21 at the walls 4. In the case of a construction as in Figures 1 and 2, where unattached bars are used between the base plate and the cover plate (with or without a corrosion protection layer), a leakage can be achieved by reducing the force used to press the base plate and the cover plate towards the walls. In this way, it will be easier for the cooling fluid to flow through the gaps between the walls and the base plate or the cover plate. Tolerances used for dimensioning the various parts can be utilized for accomplishing the desired leakage. Alternatively, grooves or holes can be made in the walls, as illustrated in Figures 5 and 6.

Figures 5 and 6 show side views of alternative walls 34 and 44 for the cooling element of Figures 1 and 2.

Similarly, as explained in connection with Figures 1 and 2, the walls of Figures 5 and 6 might consist of unattached bars, which are kept in place in the cooling element simply by the forces caused by the base plate and the cover plate. Alternatively, the walls 34 and 44 may be fixedly attached to the base plate and/or the cover plate by welding, soldering or gluing, for instance. A fluid-tight non-leaking seam between the walls and the base plate and/or the cover plate (with or without a corrosion protection layer) is acceptable as a sufficient leakage is accomplished with the grooves 45 or the holes in the walls. These grooves 45 or holes are dimensioned to allow a suitable amount of cooling fluid to leak past the wall 34 and 44 between parts of the flow channel located on the opposite sides of the walls.

Figures 7 to 13 show cross sections of alternative walls for the cooling element of Figures 1 and 2. The walls of Figures 7 to 13 might consist of unattached elongated bars or alternatively of fixed walls attached to the base plate or the cover plate.

Figure 7 illustrates a wall with a circular cross section. Figures 8 and 9 illustrate a wall with a triangular cross section where an edge 50 is arranged to be pressed against the base plate or the cover plate.

Figure 10 illustrates a wall with a triangular cross section, however, with two edges 51 arranged to be pressed against the base plate or the cover plate.

The wall of Figure 11 is fixedly attached to one of the base plate and the cover plate, and it comprises an edge to be pressed against the other one of the base plate and the cover plate.

In Figures 12 and 13 the walls consist of a bar with a circular cross section. In order to reduce the leakage as compared to the embodiment of Figures 1 and 2, additional smaller bars with a circular or rectangular cross section have been fixedly attached to the base plate or the cover plate on the opposite sides (or on one side) or the unattached circular bar. It is also possible to utilize a wall consisting of a bar with a rectangular cross section only, instead of the combination of a circular bar and a rectangular bar as shown in Figure 13.

It is to be understood that the above description and the accompanying figures are only intended to illustrate the present invention. It will be obvious to those skilled in the art that the invention can be varied and modified also in other ways without departing from the scope of the invention.

## Claims

1. Cooling element (1, 10, 20) for an electrical circuit (12), comprising:
a base plate (3),
a cover plate (2) with a first surface (7) for receiving said electrical circuit (12),
walls (4, 34, 44) extending between said base plate (3) and a second surface (9) of said cover plate (2), said walls limiting a flow channel extending back and forth between the base plate (3) and the cover plate (2),
an inlet (5) for introducing a cooling fluid into said flow channel, and
an outlet (6) for removing said cooling fluid from said flow channel,
**characterized in that**
at least one leak point (21) is arranged at said walls (4, 34, 44) to allow a part of said cooling fluid (11) to leak past at least one of said walls between parts of the flow channel which are located on opposite sides of said at least one wall (4, 34, 44).

2. The cooling element of claim 1, **characterized in that** said base plate (3) is a stiff base plate of a material with good heat conducting properties arranged to be pressed towards said walls.

3. The cooling element of claim 1 or 2, **characterized in that** said cooling element comprises a corrosion protection layer (8) arranged against said second surface (9) of the cover plate (2) to prevent said cooling fluid (11) and said walls (4) from contacting said cover plate (2).

4. The cooling element of one of claims 1 to 3, **characterized in that** said at least one leak point (21) consists of a gap between said at least one wall (4) and the base plate (3), cover plate (2) or corrosion protection layer (8).

5. The cooling element of one of claims 1 to 4, **characterized in that** said at least one leak point (21) consists of a groove (45) or hole in said at least one wall (34, 44).

6. The cooling element of one of claims 1 to 5, **characterized in that** said at least one wall (4) consists of a bar with a circular cross section.

7. The cooling element of one of claims 1 to 5, **characterized in that** said at least one wall (4) consists of a bar with a rectangular cross section.

8. The cooling element of one of claims 1 to 7, **characterized in that** said at least one wall consists of an elongated bar with an edge (50) pressed against the base plate (3), cover plate (2) or corrosion protection layer (8) in order to separate from each other said parts of the flow channel which are located on the opposite sides of said at least one wall.

9. The cooling element of claim 8, **characterized in that** said elongated bar comprises two parallel edges (51) arranged at a distance from each other and pressed against the base plate (3), cover plate (2) or corrosion protection layer (8).

10. The cooling element of one of claims 1 to 9, **characterized in that** said at least one wall is fixedly attached to the base plate (3) or to the cover plate (2).

11. The cooling element of one of claims 1 to 9, **characterized in that** said at least one wall (4) consists of an unattached elongated bar, which is kept steady in the cooling element (1) only by a force used to press the base plate (3) and the cover plate (2) or corrosion protection layer (8), respectively, towards the elongated bar.
